# EUROPEAN PATENT APPLICATION

(11) **EP 4 394 930 A1**
(43) Date of publication of application: **03.07.2024**
(21) Application number: 23807969.3
(22) Date of filing: 22.05.2023
(51) Int. Cl.: H01M 4/36, H01M 4/525, C01G 53/00, H01M 4/02

(54) **CATHODE ACTIVE MATERIAL AND PREPARATION METHOD THEREFOR**

(30) Priority: 20.05.2022 KR 20220062249
(71) Applicant: LG Chem, Ltd., Yeongdeungpo-gu Seoul 07336 (KR)
(72) Inventor: LEE, Eung Ju, Daejeon 34122 (KR); BAEK, Hyeon Hui, Daejeon 34122 (KR); JEONG, Jong Seok, Daejeon 34122 (KR); KIM, Jong Pil, Daejeon 34122 (KR); JUNG, Won Sig, Daejeon 34122 (KR); RHEE, Tae Young, Daejeon 34122 (KR); CHOI, Hwan Young, Daejeon 34122 (KR)
(74) Representative: Hoffmann Eitle
(86) International application number: PCT/KR2023/006946
(87) International publication number: WO 2023/224450

(57) **Abstract**

The present invention relates to a positive electrode active material including: a lithium transition metal oxide which is in the form of a single particle and divided into a surface part and a core; and a coating part which is formed on the outer surface of the surface part and contains cobalt, wherein the surface part has a layered (R-3m) structure, and nickel included in the surface part has an average oxidation number of +2.36 to +3.00, and a method for producing the positive electrode active material.

## Description

### TECHNICAL FIELD

This application claims the benefit of Korean Patent Application No. 10-2022-0062249, filed on May 20, 2022, in the Korean Intellectual Property Office, the disclosure of which is incorporated herein in its entirety by reference.

The present invention relates to a positive electrode active material and a method for producing the same.

### BACKGROUND ART

Recently, as technology in electric vehicles, etc. is developed, demand for high-capacity secondary batteries has been increasing, and accordingly, research on a positive electrode using a high-Ni positive electrode active material having excellent capacity characteristics has been actively carried out.

Since the co-precipitation method is used to produce the high-Ni positive electrode active material, the produced high-Ni positive electrode active material has the form of a secondary particle in which primary particles are aggregated. However, the active material having the form of the secondary particle has the disadvantages that fine cracks are generated in the secondary particle during a long charging and discharging process to cause a side reaction, and the secondary particle also causes the structure of the secondary particle to collapse when the electrode density is increased in order to improve the energy density, thereby causing a decrease in energy density and a deterioration in life characteristics due to a reduction in the active material and an electrolyte solution.

In order to solve the limitation of the high-nickel positive electrode active material in the form of secondary particles, recently, a single particle-type nickel-based positive electrode active material is being developed. The single particle-type nickel-based positive electrode active material has the advantage that particle collapse does not occur even when the electrode density is increased for a high energy density. However, since the single particle-type nickel-based positive electrode active material requires a relatively high sintering temperature in order to produce the same, the layered structure of R-3m is not properly maintained, and as lithium escapes from the crystal structure, the phase changes to the Fm-3m rock-salt structure such as NiO and the crystallinity of the positive electrode active material deteriorates, and thus the ratio of NiO increases on the surface part of the produced single particle, and there are limitations in that as NiO increases, the resistance increases, and the energy density and the output decrease. In addition, in the case where the sintering temperature is lowered, the single particle-type nickel-based positive electrode active material is present in the form of an over-sintered secondary particle, and thus there is a limitation in that effects of improving a life and gas generation do not reach a level that is expected for the single particle.

Accordingly, there remains a need for development on a positive electrode active material having a high electrode density and exhibiting excellent life characteristics and output characteristics.

### [Prior Art Document]

### [PATENT DOCUMENT]

(Patent Document 1) KR 2019-0094529 A1

### DISCLOSURE OF THE INVENTION

### TECHNICAL PROBLEM

An aspect of the present invention provides a positive electrode active material having a high electrode density and exhibiting excellent life characteristics and output characteristics.

Another aspect of the present invention provides a method for producing a positive electrode active material having a high electrode density and exhibiting excellent life characteristics and output characteristics.

### TECHNICAL SOLUTION

According to an aspect of the present invention, there is provided a positive electrode active material.
(1) The present invention provides a positive electrode active material including: a lithium transition metal oxide which is in the form of a single particle and divided into a surface part and a core; and a coating part which is formed on the surface part and contains cobalt, wherein the surface part has a layered (R-3m) structure, and nickel included in the surface part has an average oxidation number of +2.36 to +3.00.
(2) In (1) above, the present invention provides the positive electrode active material, wherein the surface part is a region from the outermost surface of the lithium transition metal oxide in the form of a single particle to a depth of 1 nm to 50 nm toward the center.
(3) In (1) or (2) above, the present invention provides the positive electrode active material, wherein the cobalt and nickel satisfy a Co/Ni value (mol/mol) of 0.10 to 0.80 based on the entirety of the surface part and the coating part.
(4) In any one of (1) to (3) above, the present invention provides the positive electrode active material, wherein the coating part is formed in the outer surface of the surface part of 10% to 100% based on the total area of the outer surface of the surface part of the lithium transition metal oxide.
(5) In any one of (1) to (4) above, the present invention provides the positive electrode active material, wherein the coating part is positioned in the form of islands on the outer surface of the surface part.
(6) In any one of (1) to (5) above, the present invention provides the positive electrode active material, wherein the coating part includes a composition of LiCoO₂.
(7) In any one of (1) to (6) above, the present invention provides the positive electrode active material, wherein the lithium transition metal oxide in the form of a single particle includes at most 50 crystalline grains.
(8) In any one of (1) to (7) above, the present invention provides the positive electrode active material, wherein the surface part includes a layered structure of nickel cobalt manganese oxide converted from a NiO layer.
(9) In any one of (1) to (8) above, the present invention provides the positive electrode active material, wherein the lithium transition metal oxide is a lithium composite transition metal oxide including nickel, cobalt, and manganese.
(10) In any one of (1) to (9) above, the present invention provides the positive electrode active material, wherein the lithium transition metal oxide is a lithium composite transition metal oxide represented by Formula 1 below:

   [Formula 1] LiₐNiₓCo_{y}M¹_{z}M²_{1-x-y-z}O₂

In Formula 1 above, M¹ is at least one selected from the group consisting of Mn and Al, M² is at least one selected from the group consisting of B, Ba, Ce, Cr, F, Mg, V, Ti, Fe, Zr, Zn, Si, Y, Nb, Ga, Sn, Mo, W, P, S, Sr, Ta, La, and Hf, 1.0≤a≤1.3, 0.6≤x<1.0, 0≤y≤0.4, and 0≤z≤0.4.

(11) In any one of (1) to (10) above, the present invention provides the positive electrode active material, wherein the lithium transition metal oxide is a lithium composite transition metal oxide represented by Formula 2 below:

[Formula 2] LiₐNi_{b}Co_{c}Mn_{d}M¹ₑO₂

where, in Formula 2 above, M¹ is at least one selected from the group consisting of Al, Zr, B, W, Mo, Cr, Nb, Mg, Hf, Ta, La, Ti, Sr, Ba, Ce, Sn, Y, Zn, F, P, and S, 0.9≤a≤1.1, 0.8≤b<1, 0<c<0.2, 0<d<0.2, 0≤e<0.1, and b+c+d+e=1.

In addition, according to another aspect of the present invention, there is provided a method for producing a positive electrode active material.

(12) The present invention provides a method for producing a positive electrode active material, the method including the steps of: 1) mixing lithium transition metal oxide particles in the form of a single particle with a cobalt source; and 2) heat-treating the mixture in step 1).

(14) In (12) above, the present invention provides the method, wherein in step 1), an additional metal source is further mixed.

(15) In (12) or (13) above, the present invention provides the method, wherein the heat-treating in step 2) is performed at 500-800 °C.

### ADVANTAGEOUS EFFECTS

The positive electrode active material of the present invention is a positive electrode active material including a lithium transition metal oxide in the form of a single particle, wherein the positive electrode active material has a surface part having a reduced NiO layer while including a coating part containing cobalt, and thus may have high electrode density, and exhibit excellent life characteristics and output characteristics.

### BRIEF DESCRIPTION OF THE DRAWINGS

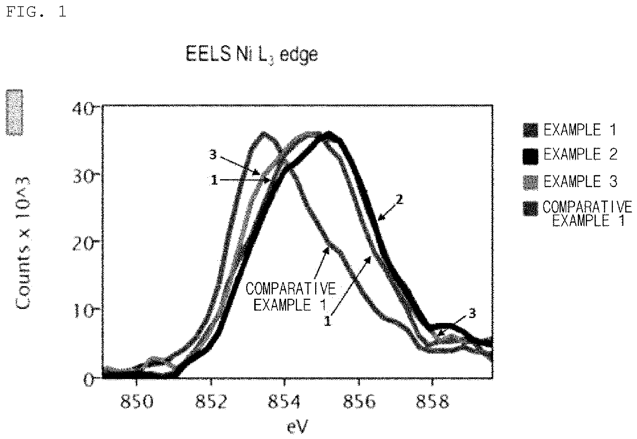

FIG. 1 is a graph showing EELS measurement results with respect to Examples 1 to 3 and Comparative Example 1.

### MODE FOR CARRYING OUT THE INVENTION

Hereinafter, the present invention will be described in more detail to aid in understanding the present invention.

It will be understood that words or terms used in the description and claims of the present invention shall not be construed as being limited to having the meaning defined in commonly used dictionaries. It will be further understood that the words or terms should be interpreted as having meanings that are consistent with their meanings in the context of the relevant art and the technical idea of the invention, based on the principle that an inventor may properly define the meaning of the words or terms to best explain the invention.

As used herein, the term "primary particle" refers to a minimum particle unit distinguished as a single lump when the cross-section of the positive electrode active material is observed through a scanning electron microscope (SEM), and may be composed of a plurality of crystalline grains.

As used herein, the term "secondary particle" refers to a secondary structure formed by aggregation of a plurality of primary particles. An average particle diameter of the secondary particle may be measured through a particle size analyzer.

As used herein, the term "form of a single particle" may be used interchangeably with the term "single particle-type," and refers to a shape that contrasts with a secondary particle shape formed by aggregation of hundreds of primary particles prepared by a conventional method. In addition, the term "single particle-type positive electrode active material" or "lithium transition metal oxide in the form of a single particle" as used herein is a concept that contrasts with a positive electrode active material in the form of a secondary particle formed by aggregation of hundreds of primary particles prepared by the conventional method, and refers to a positive electrode active material or a lithium transition metal active material consisting of 1-50 particles, 1-40 particles, 1-30 particles, 1-20 particles, 1-15 particles, 1-10 particles, or 1-5 particles.

As used herein, the term "single crystal" may be used interchangeably with the term "single crystalline," and refers to a positive electrode active material or a lithium transition metal oxide including at most 50 crystalline grains, specifically, 1-30 crystalline grains. Typically, single crystal particles represent particles in which the entire sample consists of only a single crystalline grain or grain region. In the present invention, the single particle-type positive electrode active material or the lithium transition metal oxide in the form of a single particle may exhibit characteristics similar to those of a single crystal particle by including a few crystalline grains.

The "single particle" refers to a minimum unit of a particle recognized when a positive electrode active material is observed through a scanning electron microscope, and the "crystalline grain" or "grain region" refers to a region in which atoms in a sample are continuously and periodically arranged in one direction. The crystalline grains may be analyzed using an electron backscatter diffraction (EBSD) analyzer.

As used herein, the term "average particle diameter (D₅₀)" refers to a particle diameter at 50% of a volume cumulative distribution according to the particle diameter. With respect to the average particle diameter, D₅₀ may be measured by dispersing powder to be measured in a dispersion medium, introducing the powder into a commercially available laser diffraction particle size measuring apparatus (for example, S3500 made by Microtrac, Inc.), measuring a difference in diffraction pattern according to a particle size when the particles pass through a laser beam to calculate a particle size distribution, and calculating a particle diameter at 50% of a volume cumulative distribution according to the particle diameter in the measuring apparatus.

A positive electrode active material of the present invention includes: a lithium transition metal oxide which is in the form of a single particle and divided into a surface part and a core; and a coating part which is formed on the surface part and contains cobalt, wherein the surface part has a layered (R-3m) structure, and nickel included in the surface part has an average oxidation number of +2.36 to +3.00.

The surface part of the lithium transition metal oxide in the form of a single particle has a layered (R-3m) structure, and a high NiO content before the coating part containing cobalt is formed on the surface part, and the formation of said NiO is induced by the high sintering temperature required for the preparation of the lithium transition metal oxide in the form of a single particle. NiO included in the surface part of the lithium transition metal oxide in the form of a single particle may cause an increase in resistance, and decreases in energy density and output.

The positive electrode active material of the present invention includes the coating part containing cobalt formed through a process for mixing the lithium transition metal oxide in the form of a single particle with a cobalt source (raw material) and then heat-treating the mixture, and the coating part may be a layer formed as the cobalt diffuses from the surface of the lithium transition metal oxide in the form of a single particle toward the center during the heat treatment process. During the process of forming the coating part, the NiO layer of the surface part is converted into a layered structure of nickel cobalt manganese (NCM) oxide, thereby reducing and eliminating causes of resistance increase, energy density decrease, output decrease, and the like, and thus the positive electrode active material of the present invention may exhibit excellent electrochemical properties.

The lithium transition metal oxide in the form of a single particle is divided into the surface part and the core. The surface part represents the outer surface of the lithium transition metal oxide in the form of a single particle, and means a region having a predetermined thickness from the outermost surface of the lithium transition metal oxide in the form of a single particle toward the center, and specifically, means a region from the outermost surface of the lithium transition metal oxide in the form of a single particle to a depth of 1 nm to 50 nm toward the center, specifically, 5 nm to 30 nm.

In addition, the core refers to the inside of the lithium transition metal oxide in the form of a single particle except the surface part.

The average oxidation number of the nickel included in the surface part may be specifically, +2.36 to +2.95, +2.36 to +2.91, +2.37 to +2.95, and more specifically, +2.37 to +2.91. The average oxidation number of the nickel included in the surface part may vary with the coating amount of the cobalt forming the coating part, and when the above range is satisfied, an appropriate amount of the coating part is formed on the surface, so that the NiO degradation layer of the lithium transition metal oxide is sufficiently converted into a layered structure of nickel cobalt manganese (NCM) oxide, thereby preventing the limitations of cation mixing and structural instability due to the collapse of a layered structure of the NiO degradation layer. Accordingly, the surface part may include the layered structure of the nickel cobalt manganese oxide converted from the NiO layer.

The average oxidation number of nickel (Ni) from the outermost surface of the lithium transition metal oxide in the form of a single particle to a depth of 10 nm toward the center may be +2.50 to +3.00, specifically, +2.50 to +2.95, +2.50 to +2.90, +2.50 to +2.88, +2.52 to +2.95, +2.52 to +2.90, or +2.52 to +2.88, and more specifically +2.54 to +2.86. If the average oxidation number of the nickel satisfies the average oxidation number range up to 10 nm, an appropriate reduction effect may be obtained for the NiO degradation layer of the lithium transition metal oxide in the form of a single particle.

The coating part may be formed on the outer surface of the surface part, that is, the outermost surface of the lithium transition metal oxide in the form of a single particle, may be formed on a portion or the whole of the outer surface of the surface part, and may be formed in a region of 10% to 100% (area %) based on the total outer surface area of the surface part. Specifically, the coating part may be formed on a portion of the outer surface of the surface part, and may be formed in region of 30% to 90% based on the total outer surface area of the surface part.

The coating part may be formed in the form of islands on the outer surface of the surface part. The form of islands refers to a shape formed discontinuously on the outer surface of the surface part, that is, the coating part may be partially dispersed and distributed on the outermost surface of the lithium transition metal oxide in the form of a single particle.

The coating part may include a composition of LiCoO₂, and specifically, the coating part may be included as LiCoO₂ in the form of islands on the outer surface of the surface part.

The cobalt and nickel may satisfy a Co/Ni value (mol/mol) of 0.10 to 0.80, specifically, 0.15 to 0.80, 0.20 to 0.80, 0.10 to 0.75, 0.15 to 0.75, and more specifically, 0.20 to 0.75, based on the entirety of the surface part and the coating part. When the Co/Ni value is less than the above range, cobalt is excessively diffused into the lithium transition metal oxide particle in the form of a single particle, so that the cobalt concentration of the surface layer is lowered, making it difficult to exhibit the effect of forming the coating part containing cobalt, and in the process of excessively diffusing cobalt into the particle, the NiO degradation layer may be formed again on the surface of the particle. In addition, when the Co/Ni value is greater than the above range, the coated cobalt may be present on the particle surface as a separate oxide in the form of Co₃O₄ or lithium cobalt oxide (LiₓCo_{y}O_{z}), and in this case, the NiO degradation layer of the lithium transition metal oxide in the form of a single particle may not be sufficiently converted into a layered structure of nickel cobalt manganese (NCM) oxide, and an unnecessary amount of the coating part formed on the surface of the lithium transition metal oxide may act as resistance or may cause a decrease in capacity.

The lithium transition metal oxide in the form of a single particle may be a lithium composite transition metal oxide including nickel (Ni), cobalt (Co), and manganese (Mn).

Specifically, the lithium transition metal oxide in the form of a single particle may be a lithium composite transition metal oxide represented by Formula 1 below:

[Formula 1] LiₐNiₓCO_{y}M¹₂M²_{1-x-y-2}O₂

In Formula 1 above, M¹ is at least one selected from the group consisting of Mn and Al, M² is at least one selected from the group consisting of B, Ba, Ce, Cr, F, Mg, V, Ti, Fe, Zr, Zn, Si, Y, Nb, Ga, Sn, Mo, W, P, S, Sr, Ta, La, and Hf, 0.9≤a≤1.3, 0.6≤x<1.0, 0≤y≤0.4, and 0≤z≤0.4.

a above represents a molar ratio of lithium in the lithium transition metal oxide, and may satisfy 1.0≤a≤1.3, specifically 1.0≤a≤1.25, and more specifically 1.0≤a≤1.20.

x represents a molar ratio of nickel in the total transition metals, and may satisfy 0.6≤x<1.0, specifically, 0.6≤x≤0.99 or 0.70≤x≤0.99, and more specifically, 0.8≤x≤0.95. If the nickel content satisfies the above range, excellent capacity characteristics may be achieved.

y above represents a molar ratio of cobalt in the total transition metals, and may satisfy 0≤y≤0.40, specifically 0≤y≤0.35, and more specifically, 0.01≤y≤0.30.

z above represents a molar ratio of element M¹ in the total transition metals, and may satisfy 0≤z≤0.40, specifically, 0≤z<0.35, and more specifically, 0.01≤z≤0.30.

1-x-y-z above represents a molar ratio of M² in the total transition metals, and may satisfy 0≤1-x-y-z≤0.4, specifically, 0≤1-x-y-z≤0.35, and more specifically, 0≤1-x-y-z≤0.30.

In addition, particularly, the lithium transition metal oxide may be a lithium composite transition metal oxide represented by Formula 2 below:

[Formula 2] Li_{b}Ni_{c}Co_{d}MnₑM¹_{f}O₂

In Formula 2 above, M¹ is at least one selected from the group consisting of Al, Zr, B, W, Mo, Cr, Nb, Mg, Hf, Ta, La, Ti, Sr, Ba, Ce, Sn, Y, Zn, F, P, and S, 0.9≤b≤1.1, 0.8≤c<1, 0<d<0.2, 0<e<0.2, 0≤f<0.1, and c+d+e+f=1.

In addition, particularly, the lithium transition metal oxide may be a lithium composite transition metal oxide represented by Formula 3 below:

[Formula 3] Li_{g}NiₕCoᵢMnⱼO₂

In Formula 2 above, 0.9≤g≤1.1, 0.8≤h<1, 0<i<0.2, 0<j<0.2, and h+i+j=1.

The positive electrode active material may have an average particle diameter (D₅₀) of 1-50 µm in consideration of a specific surface area and a positive electrode mixture density, and specifically, may have an average particle diameter (D₅₀) of 2-20 µm. The positive electrode active material according to an example of the present invention may be a single particle-type positive electrode active material formed by aggregation of particles having an average particle diameter (D₅₀) of 0.1 µm to 10 µm. If the average particle diameter of the particles satisfies the above range, the positive electrode active material may have the advantages in a rolling ratio, an electrode void, and the like, and if the average particle diameter is less or greater than the above range, the performance may be deteriorated in an electrode capacity, life characteristics, resistance, and the like.

The present invention also provides a method for producing the positive electrode active material.

The positive electrode active material may be prepared by the production method including the steps of: 1) mixing lithium transition metal oxide particles in the form of a single particle with a cobalt (Co) source; and 2) heat-treating the mixture in step 1).

In step 1), the cobalt source may be used in an amount of 0.1 mol% to 10 mol%, specifically, 0.5 mol% to 5 mol%, and more specifically, 1 mol% to 3 mol%, based on the positive electrode active material. If the cobalt source is used in an amount less than the amount in the above range, a sufficient coating part may not be formed on the outer surface of the surface part of the lithium transition metal oxide particle, and if the cobalt source is used in an amount greater than the amount in the above range, a coating part may be formed more than necessary or unreacted cobalt compounds may remain on the particle surface, resulting in disadvantages such as an increase in resistance and a decrease in capacity.

In step 1), a process for further mixing an additional metal source may be performed. The additional metal source may be used together with the cobalt source to be coated on the surface part of the lithium transition metal oxide in the form of a single particle through a subsequent step. The coating formed by the additional metal source may be mixed with the coating part, formed on the outer surface of the surface part of the lithium transition metal oxide particles in the form of a single particle, to be coated together or may be formed as a separate coating. The additional metal source may be coated on the surface part of the lithium transition metal oxide in the form of a single particle to be formed as the form of a metal oxide, a lithium metal oxide, a cobalt metal oxide, or a lithium cobalt metal oxide.

The mixing of step 1) may be dry-mixing, for example, mixing a powder-type cobalt source material with the lithium transition metal oxide in the form of a single particle without a solvent. Such dry mixing may be a simple mixing process, and may exhibit the advantages of cost reduction and quality stabilization by simplifying processes.

In step 2) of heat-treating the mixture in step 1), the coating part is formed as the cobalt diffuses from the surface of the lithium transition metal oxide in the form of a single particle toward the center. When the coating part is formed, the coating part in the form of islands may be discontinuously formed on the surface of the lithium transition metal oxide. In the method for producing a positive electrode active material according to an embodiment of the present invention, the lithium transition metal oxide particles in the form of a single particle are dry-mixed with the cobalt (Co) source, and then heat-treated, and thus the coating part may be formed in the form of islands.

The heat treatment of step 2) may be performed at 500 °C to 800 °C, specifically, at 600 °C to 800 °C, and more specifically, at 650 °C to 750 °C.

If the heat treatment temperature satisfies the above range, the cobalt present on the surface of the lithium transition metal oxide in the form of a single particle during the heating process for heat treatment, specifically the cobalt, which is formed in the form of islands on the surface of the lithium transition metal oxide and is present in the phase of LiCoO₂, permeates into the lithium transition metal oxide in the form of a single particle to an appropriate depth, thereby appropriately changing the NiO layer, which is the degradation layer, into the layered structure of the nickel cobalt manganese (NCM) oxide, and accordingly, the surface part of the lithium transition metal oxide in the form of a single particle has a layered (R-3m) structure, and the surface part includes an oxidation number gradient layer in which the oxidation number of nickel increases toward the outermost surface, thereby exhibiting excellent effects in cell performance such as charge and discharge capacity, initial efficiency, and initial resistance. If the heat treatment temperature of step 2) is low, the thickness of the coating part is increased and the coating part is formed excessively, thereby making it difficult to exhibit the advantages of the formation of the coating part as described above, and if the heat treatment temperature of step 2) is high, cobalt is deeply doped into the lithium transition metal oxide in the form of a single particle, and thus the coating part may not be properly formed on the surface part.

The heat treatment of step 2) may be performed for 2 hours to 12 hours, specifically, 2 hours to 9 hours, and more specifically, 2 hours to 6 hours. If the heat treatment is performed within the above time range, excellent productivity may be exhibited, and uniform sintering may be achieved at the same time.

The cobalt source may be an oxide, a hydroxide, an oxyhydroxide, a carbonate, a sulfate, a halide, a sulfide, an acetate, a nitrate, a carboxylate, which contain cobalt, a combination thereof, or the like, for example, may include Co(OH)₂, CoOOH, Co(OCOCH₃)₂·4H₂O, Co(NO₃)₂·6H₂O, Co(SO₄)₂·7H₂O, or the like, and any one or a mixture of two or more thereof may be used, and specifically, Co(OH)₂ may be used.

The additional metal source may be, for example, an oxide, a hydroxide, an oxyhydroxide, a carbonate, a sulfate, a halide, a sulfide, an acetate, a nitrate, a carboxylate which contain at least one element selected from the group consisting of Al, Ti, W, B, F, P, Mg, Fe, Cr, V, Cu, Ca, Zn, Zr, Nb, Mo, Sr, Sb, Bi, Si, Cr, Hf, Ta, La, Ba, Ce, Sn, Y, and S, or a combination thereof, and specifically may include ZnO, Al₂O₃, Al(OH)₃, AlSO₄, AlCl₃, Al-isopropoxide, AlNO₃, TiO₂, WO₃, AlF, H₂BO₃, HBO₂, H₃BO₃, H₂B₄O₇, B₂O₃, C₆H₅B(OH)₂, (C₆H₅O)₃B, [(CH₃(CH₂)₃O)₃B, C₃H₉B₃O₆, (C₃H₇O₃)B, Li₃WO₄, (NH₄)₁₀W₁₂O₄₁·5H₂O, NH₄H₂PO₄, or the like, but is not limited thereto.

The additional metal source may be used in an amount such that the total amount of the additional metal becomes 100 ppm to 50,000 ppm, specifically, 200 ppm to 10,000 ppm, based on the total number of moles of metals in the positive electrode active material. If the additional metal is included in the above range, an effect of effectively suppressing a side reaction with the electrolyte solution may be expected, and electrochemical properties may be further improved.

In an example of the present invention, the lithium transition metal oxide particles in the form of a single particle may be prepared by mixing a transition metal oxide precursor and a lithium raw material to perform primary sintering, and disintegrating the pre-sintered product prepared by the primary sintering and then performing secondary sintering.

According to another embodiment of the present invention, there is provided a positive electrode including the above-described positive electrode active material.

Specifically, the positive electrode includes a positive electrode current collector and a positive electrode active material layer which is formed on the positive electrode current collector and includes the above-described positive electrode active material.

The positive electrode current collector is not particularly limited as long as it has conductivity without causing adverse chemical changes in the battery, and, for example, stainless steel, aluminum, nickel, titanium, sintered carbon, or aluminum or stainless steel that is surface-treated with one of carbon, nickel, titanium, silver, or the like may be used. Also, the positive electrode current collector may typically have a thickness of 3 um to 500pm, and microscopic irregularities may be formed on the surface of the current collector to improve the adhesion of the positive electrode active material. For example, the positive electrode current collector may be used in various forms such as a film, a sheet, a foil, a net, a porous body, a foam, and a non-woven body.

The positive electrode active material layer may include a conductive agent and a binder in addition to the above-described positive electrode active material.

In this case, the conductive agent is used to provide conductivity to the electrode, and any conductive agent may be used without particular limitation as long as it has electron conductivity without causing adverse chemical changes in the battery to be constituted. Specific examples of the conductive agent may be graphite such as natural graphite or artificial graphite; carbon based materials such as carbon black, acetylene black, Ketjen black, channel black, furnace black, lamp black, thermal black, and carbon fibers; powder or fibers of metal such as copper, nickel, aluminum, and silver; conductive whiskers such as zinc oxide whiskers and potassium titanate whiskers; conductive metal oxides such as titanium oxide; or conductive polymers such as polyphenylene derivatives, and any one thereof or a mixture of two or more thereof may be used. The conductive agent may be typically included in an amount of 1 wt% to 30 wt% based on the total weight of the positive electrode active material layer.

The binder serves to improve binding between positive electrode active material particles and the adhesion between the positive electrode active material and the current collector. Specific examples of the binder may be polyvinylidene fluoride (PVDF), polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated EPDM, a styrene-butadiene rubber (SBR), a fluorine rubber, or various copolymers thereof, and any one thereof or a mixture of two or more thereof may be used. The binder may be included in an amount of 1 wt% to 30 wt% based on the total weight of the positive electrode active material layer.

The positive electrode may be manufactured according to a typical method for manufacturing a positive electrode except that the above-described positive electrode active material is used. Specifically, a composition for forming a positive electrode active material layer, which is prepared by mixing or dispersing the above-described positive electrode active material as well as optionally the binder and the conductive agent in a solvent, is coated on the positive electrode current collector, and the positive electrode may then be prepared by drying and rolling the coated positive electrode current collector. In this case, the type and content of the positive electrode active material, the binder, and the conductive agent are the same as those described above.

The solvent may be a solvent normally used in the art. The solvent may include dimethyl sulfoxide (DMSO), isopropyl alcohol, N-methylpyrrolidone (NMP), acetone, or water, and any one thereof or a mixture of two or more thereof may be used. An amount of the solvent used may be sufficient if the solvent may dissolve or disperse the positive electrode active material, the conductive agent, and the binder in consideration of a coating thickness of a slurry and manufacturing yield, and may allow to have a viscosity that may provide excellent thickness uniformity during the subsequent coating for the preparation of the positive electrode.

Also, as another method, the positive electrode may be prepared by casting the composition for forming a positive electrode active material layer on a separate support and then laminating a film separated from the support on the positive electrode current collector.

According to another example of the present invention, an electrochemical device including the positive electrode is provided. The electrochemical device may specifically be a battery or a capacitor, and, for example, may be a lithium secondary battery.

The lithium secondary battery specifically includes a positive electrode, a negative electrode disposed to face the positive electrode, a separator disposed between the positive electrode and the negative electrode, and an electrolyte, wherein the positive electrode is as described above. Also, the lithium secondary battery may further selectively include a battery container accommodating an electrode assembly of the positive electrode, the negative electrode, and the separator, and a sealing member sealing the battery container.

In the lithium secondary battery, the negative electrode includes a negative electrode current collector and a negative electrode active material layer positioned on the negative electrode current collector.

The negative electrode current collector is not particularly limited as long as it has high conductivity without causing adverse chemical changes in the battery, and, for example, copper, stainless steel, aluminum, nickel, titanium, fired carbon, copper or stainless steel that is surface-treated with one of carbon, nickel, titanium, silver, or the like, and an aluminum-cadmium alloy may be used. Also, the negative electrode current collector may typically have a thickness of 3 um to 500 µm, and, similar to the positive electrode current collector, microscopic irregularities may be formed on the surface of the current collector to improve the adhesion of a negative electrode active material. For example, the negative electrode current collector may be used in various forms such as a film, a sheet, a foil, a net, a porous body, a foam, and a non-woven fabric body.

The negative electrode active material layer optionally includes a binder and a conductive agent in addition to the negative electrode active material.

A compound capable of reversibly intercalating and deintercalating lithium may be used as the negative electrode active material. Specific examples of the negative electrode active material may be a carbonaceous material such as artificial graphite, natural graphite, graphitized carbon fibers, and amorphous carbon; a metallic compound alloyable with lithium such as Si, Al, Sn, Pb, Zn, Bi, In, Mg, Ga, Cd, a Si alloy, a Sn alloy, or an Al alloy; a metal oxide which may be doped or undoped with lithium such as SiOₓ(0 < x < 2), SnO₂, vanadium oxide, and lithium vanadium oxide; or a composite including the metallic compound and the carbonaceous material such as a Si-C composite or a Sn-C composite, and any one thereof or a mixture of two or more thereof may be used. Also, a metallic lithium thin film may be used as the negative electrode active material. Furthermore, both low crystalline carbon and high crystalline carbon may be used as the carbon material. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature sintered carbon such as petroleum or coal tar pitch derived cokes.

Also, the binder and the conductive agent may be the same as those described above in the positive electrode.

The negative electrode active material layer may be prepared by, for example, coating and drying a composition for forming a negative electrode prepared by dispersing the negative electrode active material and optionally the binder and the conductive agent in a solvent on the negative electrode current collector, or by casting the composition for forming a negative electrode on a separate support and then laminating a film obtained by peeling off from the support on the negative electrode current collector.

Meanwhile, in the lithium secondary battery, the separator separates the negative electrode and the positive electrode and provides a movement path of lithium ions, wherein any separator may be used as the separator, without particular limitation, as long as it is typically used in a lithium secondary battery, and particularly, a separator having high moisture-retention ability for an electrolyte solution as well as low resistance to the transfer of electrolyte ions may be used. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous non-woven fabric, for example, a non-woven fabric formed of high melting point glass fibers or polyethylene terephthalate fibers may be used. Furthermore, a coated separator including a ceramic component or a polymer material may be used to secure heat resistance or mechanical strength, and the separator having a single layer or multilayer structure may be optionally used.

Also, the electrolyte used in the present invention may include an organic liquid electrolyte, an inorganic liquid electrolyte, a solid polymer electrolyte, a gel-type polymer electrolyte, a solid inorganic electrolyte, or a molten-type inorganic electrolyte which may be used in the manufacture of the lithium secondary battery, but is not limited thereto.

Specifically, the electrolyte may include an organic solvent and a lithium salt.

Any organic solvent may be used as the organic solvent without particular limitation so long as it may function as a medium through which ions involved in an electrochemical reaction of the battery may move. Specifically, an ester-based solvent such as methyl acetate, ethyl acetate, γ-butyrolactone, and ε-caprolactone; an ether-based solvent such as dibutyl ether or tetrahydrofuran; a ketone-based solvent such as cyclohexanone; an aromatic hydrocarbon-based solvent such as benzene and fluorobenzene; or a carbonate-based solvent such as dimethyl carbonate (DMC), diethyl carbonate (DEC), methylethyl carbonate (MEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond, an aromatic ring or ether bond); amides such as dimethylformamide; dioxolanes such as 1,3-dioxolane; or sulfolanes may be used as the organic solvent. Among these solvents, the carbonate-based solvent may be used, and, for example, a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) may be used. In this case, the performance of the electrolyte solution may be excellent when the cyclic carbonate and the chain carbonate are mixed in a volume ratio of about 1:1 to about 1:9.

The lithium salt may be used without particular limitation as long as it is a compound capable of providing lithium ions used in the lithium secondary battery. Specifically, LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, LiB(C₂O₄)₂, or the like may be used as the lithium salt. It is preferable to use the lithium salt in a concentration range of 0.1 M to 2.0 M. When the concentration of the lithium salt is in the above range, the electrolyte may have suitable conductivity and viscosity, thereby exhibiting excellent performance, and lithium ions may effectively move.

In order to improve life characteristics of the battery, suppress the reduction in battery capacity, and improve discharge capacity of the battery, at least one additive, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, *N*,*N-*substituted imidazolidine, ethylene glycol dialkyl ether, an ammonium salt, pyrrole, 2-methoxy ethanol, or aluminum trichloride, may be further included in the electrolyte in addition to the electrolyte components. In this case, the additive may be included in an amount of 0.1 wt% to 5 wt% based on a total weight of the electrolyte.

As described above, since the lithium secondary battery including the positive electrode active material according to the present invention stably exhibits excellent discharge capacity, output characteristics, and capacity retention, the lithium secondary battery is suitable for portable devices, such as mobile phones, notebook computers, and digital cameras, and electric cars such as hybrid electric vehicles (HEVs).

Thus, according to another embodiment of the present invention, a battery module including the lithium secondary battery as a unit cell and a battery pack including the battery module are provided.

The battery module or the battery pack may be used as a power source of at least one medium and large sized device of a power tool; electric cars including an electric vehicle (EV), a hybrid electric vehicle (HEV), and a plug-in hybrid electric vehicle (PHEV); or a power storage system.

A shape of the lithium secondary battery of the present invention is not particularly limited, but a cylindrical type using a can, a prismatic type, a pouch type, or a coin type may be used.

The lithium secondary battery according to the present invention may not only be used in a battery cell that is used as a power source of a small device, but may also be used as a unit cell in a medium and large sized battery module including a plurality of battery cells.

### Examples

Hereinafter, examples of the present invention will be described in detail so that a person with ordinary skill in the art to which the present invention pertains can easily carry out the present invention. The present invention may, however, be embodied in many different forms and should not be construed as being limited to the examples set forth herein.

### Preparation Example 1

A positive electrode active material precursor (composition: Ni_{0.95}Co_{0.03}Mn_{0.02}(OH)₂, and an average particle diameter (D₅₀) of 3.5 µm) and LiOH as a lithium raw material were mixed at a molar ratio of 1:1.05, and the mixture was primarily sintered at 850 °C in an oxygen atmosphere for 9 hours to prepare a pre-sintered product, the pre-sintered product was disintegrated and then secondarily sintered at 750 °C for 9 hours in an oxygen atmosphere to prepare a lithium transition metal oxide in the form of a single particle.

### Example 1

The lithium transition metal oxide in the form of a single particle prepared in Preparation Example 1 and Co(OH)₂, a cobalt source, in the form of powder (Huayou Cobalt Co., Ltd.) were mixed in amounts of 98 mol% and 2 mol%, respectively.

The mixture was heat-treated at 700 °C for 5 hours to obtain a cake-state positive electrode active material, which was pulverized to prepare a single particle-type positive electrode active material in the form of powder.

### Example 2

A single particle-type positive electrode active material in the form of powder was prepared in the same manner as in Example 1, except that the mixture was heat-treated at 740 °C in Example 1.

### Example 3

A single particle-type positive electrode active material in the form of powder was prepared in the same manner as in Example 1, except that the mixture was heat-treated at 660 °C in Example 1.

### Comparative Example 1

A lithium transition metal oxide in the form of a single particle prepared in Preparation Example 1 above was used as a positive electrode active material in the form of a single particle.

### Comparative Example 2

A single particle-type positive electrode active material in the form of powder was prepared in the same manner as in Example 1, except that the mixture was heat-treated at 400 °C in Example 1.

### Comparative Example 3

A single particle-type positive electrode active material in the form of powder was prepared in the same manner as in Example 1, except that the mixture was heat-treated at 900 °C in Example 1.

### Comparative Example 4

The lithium transition metal oxide in the form of a single particle prepared in Preparation Example 1 and Co(OH)₂, a cobalt source, in the form of powder (Huayou Cobalt Co., Ltd.) were mixed in a ratio of 99.98 mol% and 0.02 mol%.

The mixture was heat-treated at 750 °C for 5 hours to obtain a cake-state positive electrode active material, which was pulverized to prepare a single particle-type positive electrode active material in the form of powder.

### Comparative Example 5

The lithium transition metal oxide in the form of a single particle prepared in Preparation Example 1 and Co(OH)₂, a cobalt source, in the form of powder (Huayou Cobalt Co., Ltd.) were mixed in a ratio of 99.98 mol% and 0.02 mol%.

The mixture was heat-treated at 700 °C for 5 hours to obtain a cake-state positive electrode active material, which was pulverized to prepare a single particle-type positive electrode active material in the form of powder.

### Experimental Example 1

### 1) EELS Measurement

The positive electrode active material powder was made into a thin film sample having a thickness of 100 nm to 200 nm using the Helios G4 UX FIB equipment manufactured by FEI Co., Ltd., and a Ni L3 Energy loss spectrum of the sample was measured using the Titan G2 80-200 ChemiSTEM equipment manufactured by FEI Co., Ltd. and the Gatan Continuum S EELS system, and the average Ni oxidation number of the surface part from the outermost part of the positive electrode active material to a depth of 10 nm toward the center was measured through nonlinear least-square fitting utilizing Ni²⁺ and Ni³⁺ reference spectrum. For the Ni²⁺ reference spectrum, a Ni L3 peak is formed in a region with lower energy loss, and for the Ni³⁺ reference spectrum, a Ni L3 peak is formed in a region with higher energy loss. The results thereof are presented in Table 1 and FIG. 1.

### 2) Measurement of Co/Ni in Surface Part

The ratio of the Co/Ni content of the surface of the positive electrode active material powder up to a depth of 10 nm was measured through Electron Spectroscopy for Chemical Analysis (ESCA) using K-alpha XPS equipment manufactured by Thermo Fisher Inc., and the results are shown in Table 1.

**[Table 1]**

| | Ni oxidation number (up to 10 nm) | Measurement of Co/Ni in surface part (up to 10 nm) |
|---|---|---|
| Example 1 | 2.60 | 0.33 |
| Example 2 | 2.91 | 0.20 |
| Example 3 | 2.42 | 0.75 |
| Comparative Example 1 | 2.21 | 0.06 |
| Comparative Example 2 | 2.30 | 0.83 |
| Comparative Example 3 | 2.35 | 0.09 |
| Comparative Example 4 | 2.25 | 0.11 |
| Comparative Example 5 | 2.27 | 0.12 |

Referring to Table 1, as a result of the EELS measurement, it was confirmed that in Examples 1 to 3, the oxidation number of Ni satisfied the range of +2.4 to 3.0, but in Comparative Examples 1 to 5, the oxidation number of Ni was less than +2.4 due to the effect of Ni of the degradation layer in the form of NiO having an oxidation state of +2. In addition, as a result of the Co/Ni measurement, it was confirmed that Examples 1 to 3 exhibited a Co/Ni ratio of 0.1 to 0.8, and Comparative Examples 1 to 3 exhibited a Co/Ni ratio of less than 0.1 or greater than 0.8.

Meanwhile, in Comparative Examples 4 and 5, the heat treatment of the lithium transition metal oxide in the form of a single particle and the cobalt source in the form of powder was performed at the equal or similar temperature to those in Examples 2 and 1, respectively, but a small amount of the cobalt source in the form of powder was used relative to the lithium transition metal oxide, and the Co/Ni value satisfied the range of 0.1 to 0.8, but the oxidation number of Ni was less than +2.4. Accordingly, it was confirmed that an appropriate amount of cobalt coating part should be formed in order for the oxidation number of Ni to satisfy the range of +2.4 to 3.0. In addition, referring to FIG. 1, it was confirmed that Examples 1 to 3 are in the state close to Ni³⁺ due to the formation of the Ni L3 peak in a region with higher energy loss, and Comparative Example 1 is in the state close to Ni²⁺ due to the formation of the Ni L3 peak in a region with lower energy loss.

### Experimental Example 2

### Manufacture of Positive Electrode

The positive electrode active material prepared in Example 1, carbon black (DenkaBlack, Denka Co., Ltd.) as a conductive agent, and PVdF (KF1300, Kureha Co., Ltd.) as a binder were added at a weight ratio of 95:3:2 (positive electrode active material:conductive agent:binder) in a solvent (N-methylpyrrolidone (NMP), Daejung Chemicals, Co., Ltd.) to prepare a composition for forming a positive electrode active material layer.

The prepared composition for forming a positive electrode active material layer was coated on one surface of an aluminum foil current collector having a thickness of 20 µm and dried at 135 °C for 3 hours to form a positive electrode active material layer. Subsequently, the positive electrode active material layer was rolled by a roll pressing method, and after the rolling, a positive electrode, in which a porosity of the positive electrode active material layer was 20%, was manufactured.

A positive electrode was manufactured in the same manner as in the above method by using the positive electrode active materials of Examples 2 and 3 and Comparative Examples 1 to 3, respectively, instead of the positive electrode active material prepared in Example 1.

A coin half-cell was manufactured using a lithium metal as a negative electrode together with the positive electrode.

### Evaluation of Electrochemical Properties

Using the half-cell manufactured above, electrochemical properties were evaluated as follows.

Each of the manufactured coin half-cells was charged at 25 °C until it reached 4.25 V at a constant current (CC) of 0.2 C, and then charged at a constant voltage (CV) of 4.25 V, and the charge capacity was measured by performing charging once until the charging current reached 0.05 mAh. Thereafter, the coin half-cell was allowed to stand for 20 minutes, and then discharged until it reached 2.5 V at a constant current of 0.2 C to measure the discharge capacity at the first cycle. The charging and discharging efficiency at the first cycle was evaluated.

The coin half-cell was fully charged in the same manner, and 0.2 C of discharging current was applied thereto for 10 seconds to divide, by a current, the voltage difference between immediately before the current is applied and 10 seconds after the current is applied to measure initial resistance (DCIR).

The results thereof are presented in Table 2.

**[Table 2]**

| | Charge capacity (mAh/g) | Discharge capacity (mAh/g) | Efficiency (%) | DCIR (Ω) |
|---|---|---|---|---|
| Example 1 | 244.1 | 215.3 | 88.2 | 22.1 |
| Example 2 | 243.2 | 215.7 | 88.7 | 21.6 |
| Example 3 | 223.8 | 213.1 | 87.4 | 22.4 |
| Comparative Example 1 | 240.5 | 206.4 | 85.7 | 28.9 |
| Comparative Example 2 | 240.7 | 206.1 | 85.7 | 28.6 |
| Comparative Example 3 | 241.3 | 207.2 | 85.9 | 25.8 |
| Comparative Example 4 | 241.2 | 208.3 | 86.2 | 26.3 |
| Comparative Example 5 | 240.9 | 210.1 | 86.5 | 25.7 |

Referring to Table 2 above, it may be confirmed that the positive electrode active materials of Examples 1 to 3 have an oxidation number of Ni satisfying the range of +2.4 to 3.0, and have lower initial resistance while exhibiting a higher discharge capacity and efficiency than the positive electrode active materials of Comparative Examples 1 to 5 having an oxidation number of Ni which does not satisfy the above range.

Thus, it was confirmed that the cobalt coating formed on the outer surface of the surface part allows the NiO degradation layer to become the NCM structure having a relatively high cobalt concentration, thereby improving cation mixing and structural instability due to the collapse of the layered structure, and consequently solving the limitations such as resistance increase, capacity decrease, and output decrease.

## Claims

1. A positive electrode active material comprising:
a lithium transition metal oxide which is in the form of a single particle and divided into a surface part and a core; and
a coating part which is formed on the surface part and contains cobalt,
wherein the surface part has a layered (R-3m) structure, and
nickel included in the surface part has an average oxidation number of +2.36 to +3.00.

2. The positive electrode active material of claim 1, wherein the surface part is a region from the outermost surface of the lithium transition metal oxide in the form of a single particle to a depth of 1 nm to 50 nm toward the center.

3. The positive electrode active material of claim 1, wherein the cobalt and nickel satisfy a Co/Ni value (mol/mol) of 0.10 to 0.80 based on the entirety of the surface part and the coating part.

4. The positive electrode active material of claim 1, wherein the coating part is formed in the outer surface of the surface part of 10% to 100% based on the total area of the outer surface of the surface part of the lithium transition metal oxide.

5. The positive electrode active material of claim 1, wherein the coating part is positioned in the form of islands on the outer surface of the surface part.

6. The positive electrode active material of claim 1, wherein the coating part comprises a composition of LiCoO₂.

7. The positive electrode active material of claim 1, wherein the lithium transition metal oxide in the form of a single particle comprises at most 50 crystalline grains.

8. The positive electrode active material of claim 1, wherein the surface part comprises a layered structure of nickel cobalt manganese oxide converted from a NiO layer.

9. The positive electrode active material of claim 1, wherein the lithium transition metal oxide is a lithium composite transition metal oxide comprising nickel, cobalt, and manganese.

10. The positive electrode active material of claim 1, wherein the lithium transition metal oxide is a lithium composite transition metal oxide represented by Formula 1 below:
[Formula 1] LiₐNiₓCO_{y}M¹_{z}M²_{1-x-y-z}O₂
where, in Formula 1 above, M¹ is at least one selected from the group consisting of Mn and Al, M² is at least one selected from the group consisting of B, Ba, Ce, Cr, F, Mg, V, Ti, Fe, Zr, Zn, Si, Y, Nb, Ga, Sn, Mo, W, P, S, Sr, Ta, La, and Hf, 1.0≤a≤1.3, 0.6≤x<1.0, 0≤y≤0.4, and 0≤z≤0.4.

11. The positive electrode active material of claim 1, wherein the lithium transition metal oxide is a lithium composite transition metal oxide represented by Formula 2 below:
[Formula 2] LiₐNi_{b}Co_{c}Mn_{d}M¹ₑO₂
where, in Formula 2 above, M¹ is at least one selected from the group consisting of Al, Zr, B, W, Mo, Cr, Nb, Mg, Hf, Ta, La, Ti, Sr, Ba, Ce, Sn, Y, Zn, F, P, and S, 0.9≤a≤1.1, 0.8≤b<1, 0<c<0.2, 0<d<0.2, 0≤e<0.1, and b+c+d+e=1.

12. A method for producing the positive electrode active material of claim 1, the method comprising the steps of:
1) mixing lithium transition metal oxide particles in the form of a single particle with a cobalt source; and
2) heat-treating the mixture in step 1).

13. The method of claim 12, wherein in step 1), an additional metal source is further mixed.

14. The method of claim 12, wherein the heat-treating in step 2) is performed at 500-800 °C.
